# EUROPEAN PATENT APPLICATION

(11) **EP 4 811 556 A1**
(43) Date of publication of application: **23.09.2026**
(21) Application number: 26164908.1
(22) Date of filing: 16.03.2026
(51) Int. Cl.: H01R 9/16, H01R 13/52, H05K 5/00, H01R 4/30

(54) **SEALING STRUCTURE OF ELECTRICAL COMPONENT CASE**

(30) Priority: 18.03.2025 JP 2025043850
(71) Applicant: Shindengen Electric Manufacturing Co., Ltd., Tokyo 100-0004 (JP)
(72) Inventor: SAKATA, Yutaro, Asaka City, Saitama, 351-8503 (JP); ISHII, Yasuhiro, Asaka City, Saitama, 351-8503 (JP); UCHIDA, Yoshitaka, Asaka City, Saitama, 351-8503 (JP)
(74) Representative: Wynne-Jones IP Limited

(57) **Abstract**

A sealing structure of an electrical component case, the structure including: an electrical component case having a bottomed-box-shaped case main body with an opening portion, and a cover that occludes the opening portion, the electrical component case housing an electrical component, the electrical component case being formed with a notch at a peripheral wall of the case main body; an attachment component fitted into the notch from a side of the opening portion; and a resilient seal member interposed between an edge portion of the notch and the attachment component.

## Description

### BACKGROUND

### Technical Field

The present invention relates to a sealing structure of an electrical component case.

### Related Art

A connector structure disclosed in Japanese Patent Application Laid-open (JP-A) No. 2013-152815, is configured by a connector, a casing, and an O-ring. The connector has a housing having a projection formed at an end face at which a flange portion is formed. The casing has an opening portion (through hole) at which a tapered face, that narrows on progression toward the interior of the casing, is formed. The O-ring is resilient and is disposed about the base of the projection at the end face of the connector. In this connector structure, the flange portion formed at the housing of the connector is fixed to the casing with a screw, and a space between the connector and the tapered face of the through hole of the housing is sealed by the O-ring.

In JP-A No. 2013-152815, in order to effect sealing between a casing (case) and a connector (attachment component), it is necessary to fasten the attachment component to the case with screws, as a result of which the fastening operation is complicated.

### SUMMARY

The present invention provides a sealing structure of an electrical component case with which a fastening operation for effecting sealing between a case and an attachment component is unnecessary.

A first aspect according to the present invention is a sealing structure of an electrical component case, the structure including: an electrical component case having a bottomed-box-shaped case main body with an opening portion, and a cover that occludes the opening portion, the electrical component case housing an electrical component, the electrical component case being formed with a notch at a peripheral wall of the case main body; an attachment component fitted into the notch from a side of the opening portion; and a resilient seal member interposed between an edge portion of the notch and the attachment component.

According to the first aspect, an electrical component is housed in an electrical component case including a case main body with a bottomed box-shape including an opening portion, and a cover that closes the opening portion of the case main body. A notch is formed in a peripheral wall of the case main body, and a resilient seal member is sandwiched between an attachment component that is fitted into the notch from the side of the opening portion, and an edge portion of the notch. As a result, since a space between the case main body and the attachment component is sealed, a fastening operation for sealing between the case main body and the attachment component is unnecessary.

### BRIEF DESCRIPTION OF THE DRAWINGS

Exemplary embodiment will be described in detail based on the following figures, wherein:
Fig. 1 is an exploded perspective view illustrating an electrical component case according to an exemplary embodiment;
Fig. 2 is a perspective view illustrating a portion of an electrical component case according to an exemplary embodiment;
Fig. 3 is a perspective cross-section view illustrating the configuration illustrated in Fig. 2 with a portion cut away;
Fig. 4 is a side cross-section view illustrating the configuration illustrated in Fig. 2 with a portion cut away;
Fig. 5 is a perspective view illustrating a connector, which is an attachment component;
Fig. 6 is a plan view illustrating a connector;
Fig. 7 is a plan view illustrating a portion of a connector;
Fig. 8 is a plan view corresponding to Fig. 6, illustrating a state in which a connector is fitted with a notch of a case main body; and
Fig. 9 is a plan view illustrating a situation when a fastening portion provided at a terminal of a connector is fastened to a case main body.

### DETAILED DESCRIPTION

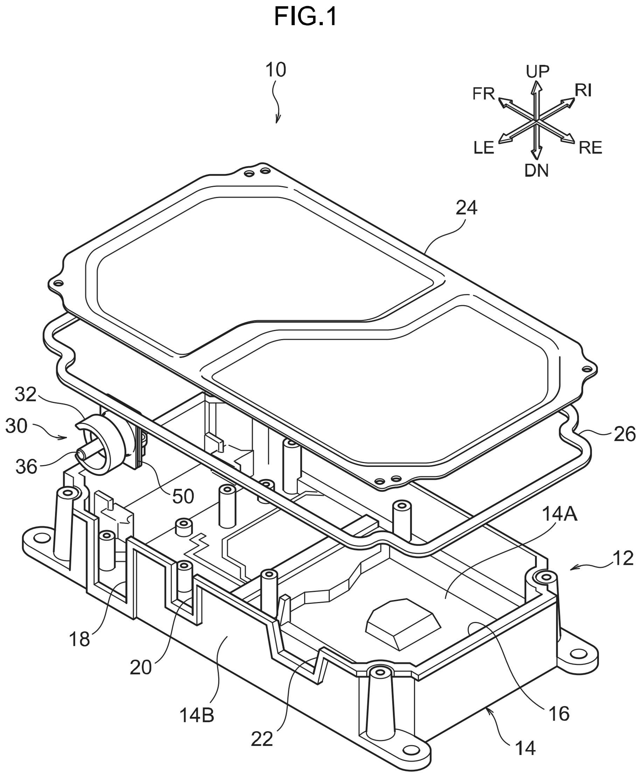

Explanation follows regarding a sealing structure 10 of an electrical component case according to an exemplary embodiment of the present invention, with reference to Figs. 1 to 9. In the present exemplary embodiment, for convenience of explanation, directions indicated by the arrows FR and RE, LE and RI, and UP and DN, as appropriate, in the respective drawings are defined as a front-rear direction, a left-right direction, and an up-down direction, and positions, orientations, and the like of constituent elements are described thereby. In the respective drawings, some reference numerals may be omitted in order to facilitate viewing of the drawings.

As illustrated in Figs. 1 to 4, a sealing structure 10 of an electrical component case according to the present exemplary embodiment is provided with an electrical component case 12, a connector 30, which is an attachment component, and a resilient seal member 50. The electrical component case 12 includes a box-shaped case main body 14 having an opening portion 16, a cover 24 that occludes the opening portion 16, and a gasket 26 that seals a space between the case main body 14 and the cover 24. The configuration is such that electrical components, not illustrated in the drawings, are housed inside the electrical component case 12. These electrical components are, for example, a power converter, a semiconductor, a substrate, or the like. Electrical devices that are configured including the electrical component case 12 are installed in a vehicle, for example.

The case main body 14 is manufactured by, for example, die casting of an aluminum alloy, and forms a flat box shape with a length direction in the front-rear direction, a width direction in the left-right direction, and a height direction in the up-down direction. The case main body 14 is configured by a bottom wall 14A and a peripheral wall 14B that stands upright from a peripheral edge of the bottom wall 14A, and is formed in a bottomed box shape including an opening portion 16 at an upper end portion thereof. Plural (here, three) notches 18, 20, 22 are formed in a row in the front-rear direction at a left side portion of the peripheral wall 14B of the case main body 14. Note that the material of the case main body 14 is not limited to an aluminum alloy, and may be a resin or the like.

The cover 24 is configured, for example, by a metal plate material that has been press-molded, and forms an elongated plate shape with a length direction in the front-rear direction, a width direction in the left-right direction, and a thickness direction in the up-down direction. The cover 24 is fastened and fixed to the upper end portion of the case main body 14 using plural screws, not illustrated in the drawings, and closes the opening portion 16 of the case main body 14.

A gasket 26 is sandwiched between the cover 24 and an upper end portion of the case main body 14. The gasket 26 is formed in a frame shape from a resilient body such as rubber or elastomer, for example, and is overlaid on an upper end portion of the case main body 14. A space between the case main body 14 and the cover 24 is sealed by the gasket 26.

The connector 30 is configured by a connector main body 32 that is manufactured by, for example, injection molding of resin, and a terminal 36 that is integrated with the connector main body 32 by means of integral molding or the like. The connector main body 32 is fitted into the notch 18 at the front-most side of the case main body 14 from the opening portion 16 side (namely, the upper side). Other components (e.g., connectors), not illustrated in the drawings, are attached to the other two notches 20, 22 of the case main body 14.

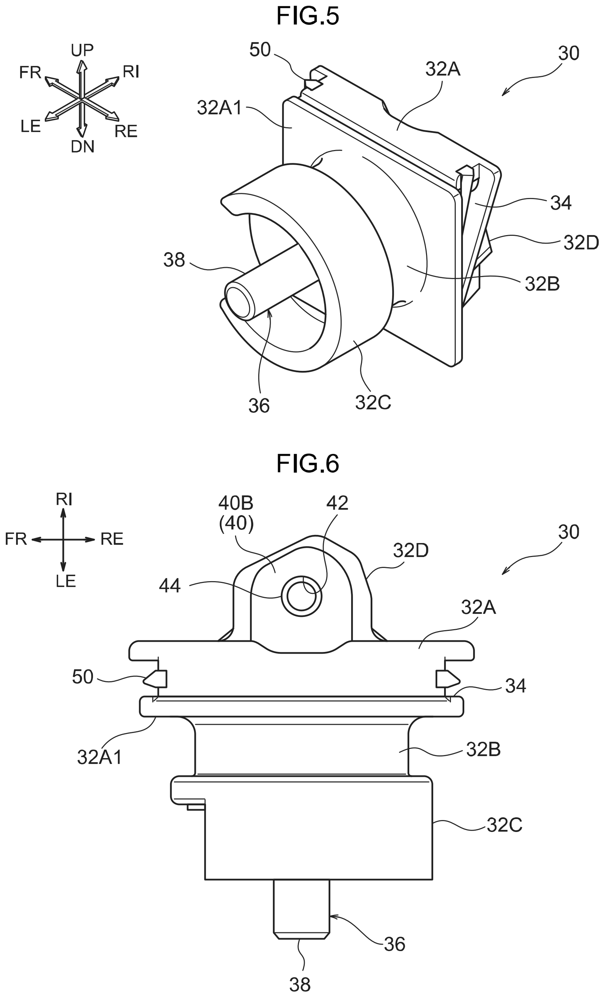

As illustrated in Figs. 5 and 6, the connector main body 32 includes a plate-shaped base portion 32A with its plate thickness direction in the left and right direction, a body portion 32B projecting in a columnar shape toward the left side from a left side face of the base portion 32A, and a socket portion 32C projecting substantially cylindrically toward the left side from a left end portion of the body portion 32B. The body portion 32B and the socket portion 32C are coaxially disposed, and the socket portion 32C is C-shaped as viewed from the left side. A groove 34, at which a front edge portion, a lower edge portion, and a rear edge portion of the notch 18 of the case main body 14 are fitted, is formed at a front end portion, a lower end portion, and a rear end portion of the base portion 32A.

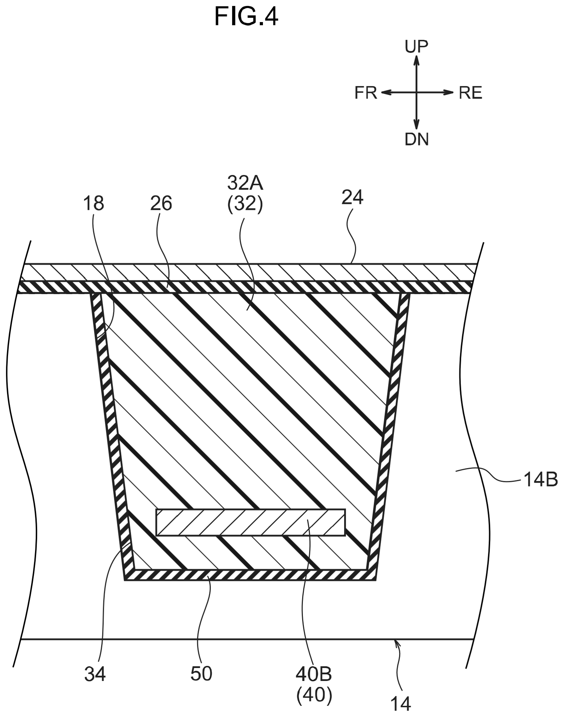

As illustrated in Fig. 4, the notch 18 forms an inverted trapezoidal shape as viewed from the left-right direction, and has a width in the front-rear direction that decreases on progression toward the bottom wall 14A-side of the case main body 14. A portion of the base portion 32A that is fitted into the notch 18 (namely, a portion at which the groove 34 is formed) has an inverted trapezoidal shape that is similar to the notch 18 as viewed from the left-right direction. A flange portion 32A1 that is rectangular in shape as viewed from the left-right direction is provided at a left end portion of the base portion 32A. Edge portions of the notch 18 are covered from the left side by the flange portion 32A1.

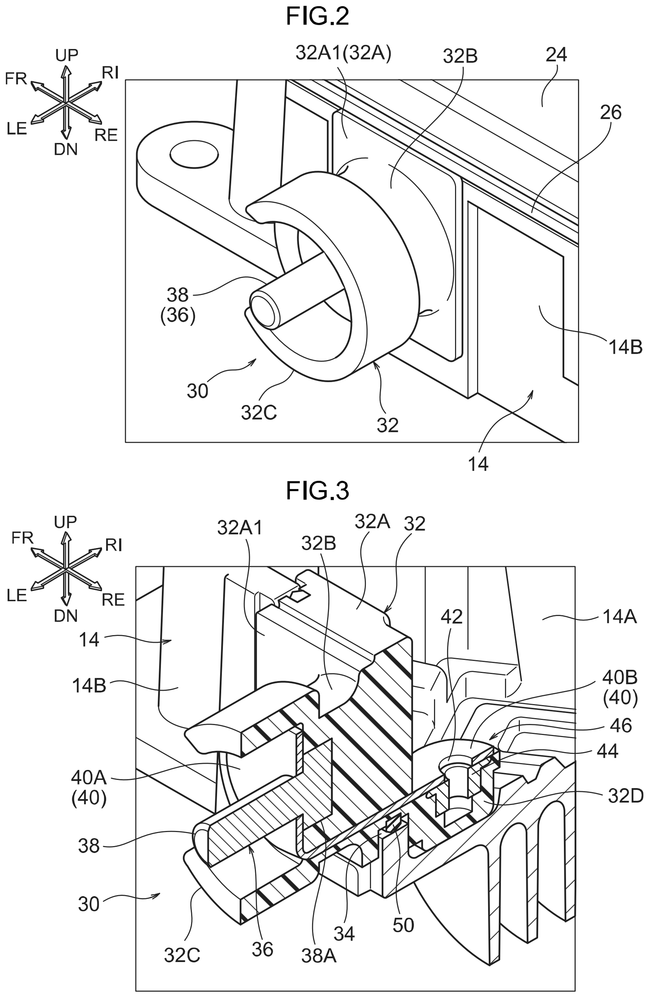

As illustrated in Fig. 3, the terminal 36 is configured by a pin portion 38 formed in a columnar shape from a metal with high conductivity, and a sheet metal portion 40 formed by press-molding a metal plate material with high conductivity. The pin portion 38 is coaxially disposed inside the socket portion 32C. A large diameter portion 38A with a larger diameter than other portions of the pin portion 38 is provided at a base end portion (one axial direction end portion) of the pin portion 38. The large diameter portion 38A is embedded coaxially inside the body portion 32B.

The sheet metal portion 40 is configured by a disk portion 40A formed in a disk shape and coaxially disposed inside the socket portion 32C, and a plate-shaped portion 40B that extends into the case main body 14 from a lower end portion of the disk portion 40A through the body portion 32B and the base portion 32A. The disk portion 40A is disposed contacting the left end face of the body portion 32B. A circular through hole (reference number not assigned) through which the pin portion 38 is inserted is formed at a center portion of the disk portion 40A.

The plate-shaped portion 40B forms an elongated plate shape with its length direction along the left-right direction and its plate thickness direction along the up-down direction. The left side portion of the plate-shaped portion 40B is embedded in the lower end portions of the body portion 32B and the base portion 32A, and the right side portion of the plate-shaped portion 40B is exposed inside the case main body 14. The connector main body 32 includes an extending portion 32D that extends into the case main body 14 from a lower end portion of the base portion 32A, and a right side portion of the plate-shaped portion 40B is overlaid on an upper surface of the extending portion 32D. A lower face of the extending portion 32D is disposed contacting an upper face of the bottom wall 14A of the case main body 14.

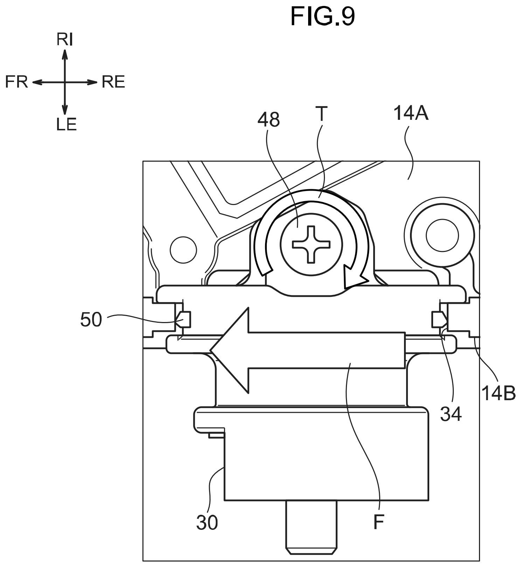

A circular through hole 42 is formed in the right side portion of the plate-shaped portion 40B, and a nut 44 is embedded inside the extending portion 32D. The nut 44 is embedded in the connector main body 32 by, for example, insert molding, and is disposed coaxially with the through hole 42. The plate-shaped portion 40B, the extending portion 32D, and the nut 44 configure a fastening portion 46. The configuration is such that another component (e.g., a terminal), not illustrated in the drawings, is fastened to the fastening portion 46 using an external screw member (see the screw 48 illustrated in Fig. 9) that is screwed into the nut 44.

As illustrated in Figs. 3 and 4, a resilient seal member 50 is sandwiched between an edge portion of the notch 18 of the case main body 14 and the base portion 32A of the connector main body 32. The resilient seal member 50 is configured, for example, by a thermoplastic elastomer. The resilient seal member 50 is integrated with the connector main body 32 by, for example, two-color molding (different material molding), and is embedded in the bottom portion of the groove 34 formed in the base portion 32A. Note that, the material of the resilient seal member 50 is not limited to a thermoplastic elastomer, and may be another type of resilient body, such as rubber or a thermosetting elastomer.

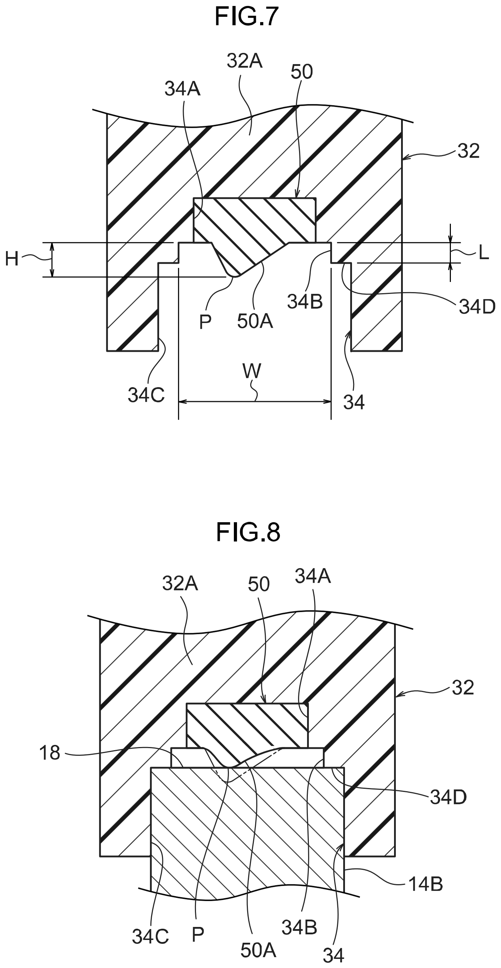

As illustrated in Figs. 7 and 8, the groove 34 formed in the base portion 32A is formed in a three-stage stepped shape, with an inward side (bottom portion side) formed with a narrower width than an outward side (opening side). Specifically, a narrow portion 34A having the smallest width is provided at the inward side of the groove 34, a wide portion 34C having the largest width is provided at the outward side of the groove 34, and an intermediate width portion 34B that is wider than the narrow portion 34A and that is narrower than the wide portion 34C is provided between the narrow portion 34A and the wide portion 34C.

The resilient seal member 50 is fitted into the narrow portion 34A, and an edge portion of the notch 18 of the case main body 14 is fitted into the wide portion 34C. The resilient seal member 50 includes a seal lip 50A protruding toward an edge portion-side of the notch 18 (namely, an outward side of the groove 34). The seal lip 50A has a substantially triangular cross-section when viewed from an extension direction of the groove 34 (in Figs. 7 and 8, a direction perpendicular to the plane of the paper). An apex point P of the cross-section of the seal lip 50A is disposed offset toward one side in a thickness direction (here, the left side) of the peripheral wall 14B of the case main body 14.

As illustrated in Fig. 7, a protrusion height H of the seal lip 50A is set higher than a dimension L of the intermediate width portion 34B in the depth direction of the groove 34. The dimension L and the above-mentioned protrusion height H are set smaller than the width dimension W of the intermediate width portion 34B. As illustrated in Fig. 8, in a state in which the edge portion of the notch 18 of the case main body 14 is fitted into the wide portion 34C, the edge portion of the notch 18 contacts a step portion 34D formed between the intermediate width portion 34B and the wide portion 34C, and the seal lip 50A is compressed by the edge portion of the notch 18. Thus, the configuration is such that a space between the edge portion of the notch 18 and the base portion 32A is sealed.

As illustrated in Fig. 4, the configuration is such that the upper face of the base portion 32A is disposed flush with the upper face of the peripheral wall 14B of the case main body 14, and a space between the upper face of the base portion 32A and the cover 24 is sealed by the gasket 26. Note that the number of seal lips 50A of the resilient seal member 50 is not limited to one, and the configuration may be such that plural seal lips 50A are disposed side-by-side in the thickness direction of the peripheral wall 14B.

When electrical devices including the electrical component case 12, the connector 30, and the like are manufactured, in an automated manufacturing line, for example, components such as the connector 30 are fitted into the notches 18, 20, 22 of the case main body 14 from above. Further, plural electrical components are housed inside the case main body 14, and another component, such as a terminal, is fastened to the fastening portion 46 of the connector 30. Thereafter, the cover 24 is fastened to the case main body 14 in a state in which the gasket 26 is sandwiched between the case main body 14, and the above-described electrical device is completed.

Prevention performance reliability tests (for example, IPX4 (JIS D 5020/ISO 20653 standard)) and mixed gas flow corrosion tests (for example, JASO C014-4 5.8 and JIS C60068-2-60 method 4) are performed on completed electrical devices. As a result, the configuration is such that products that have been confirmed to have waterproof performance and mixed gas sealing performance are consigned for delivery.

According to the present exemplary embodiment, electrical components are housed in an electrical component case 12 including a case main body 14 having a bottomed box shape including the opening portion 16, and a cover 24 that closes the opening portion 16 of the case main body 14. A notch 18 is formed in the peripheral wall 14B of the case main body 14, a resilient seal member 50 is sandwiched between a connector 30 fitted into the notch 18 from the opening portion 16-side and an edge portion of the notch 18. Since, as a result, the space between the case main body 14 and the connector 30 is sealed, a fastening operation for effecting sealing between the case main body 14 and the connector 30 is unnecessary, and manufacturing of the electrical device is facilitated.

In addition, since the connector 30 is fitted into the notch 18 of the case main body 14 from the upper side, attachment of the connector 30 to the case main body 14 can be performed on an automated manufacturing line. In contrast, in the conventional art explained in the background art section, the configuration is such that a flange portion of the connector is fastened to the peripheral wall of the housing by screws, and therefore, it is difficult to attach the connector to the casing on an automated manufacturing line. Therefore, the manufacture of the electric device can also be facilitated in this respect.

In addition, according to the present exemplary embodiment, since the resilient seal member 50 is configured by a thermoplastic elastomer, the connector main body 32 and the resilient seal member 50 can be integrally manufactured by two-color molding. This eliminates the need for a step of attaching the resilient seal member 50 to the connector main body 32, thereby facilitating manufacturing.

In addition, according to the present exemplary embodiment, the notch 18 formed in the case main body 14 has an inverted trapezoidal shape that becomes narrower on progression toward the bottom wall 14A-side of the case main body 14. As a result, the resilient seal member 50 can be easily prevented from being separated from the connector main body 32 when the connector 30 is fitted into the notch 18 of the case main body 14.

In addition, according to the present exemplary embodiment, a groove 34 is formed at the connector main body 32, the resilient seal member 50 is provided at an inward side of the groove 34, and the edge portion of the notch 18 is fitted with an outward side of the groove 34. This enables the connector main body 32 to be firmly attached to the case main body 14. In addition, the groove 34 is formed with a narrower width at the inward side than at the outward side, and the edge portion of the notch 18 contacts a step portion 34D formed between an intermediate width portion 34B and a wide portion 34C. As a result, a loose fitting between the connector main body 32 and the case main body 14 can be prevented.

In addition, according to the present exemplary embodiment, the resilient seal member 50 provided at the inward side of the groove 34 has a seal lip 50A protruding toward the edge portion-side of the notch 18 of the case main body 14. The seal lip 50A is compressed by the edge portion of the notch 18, thereby enabling effective sealing between the case main body 14 and the connector 30.

The seal lip 50A has a substantially triangular cross-section when viewed from the extension direction of the groove 34 of the connector main body 32, and an apex point P of the cross-section is disposed offset toward one thickness direction side of the peripheral wall 14B of the case main body 14. This enables the direction in which the seal lip 50A is compressed by the edge portion of the notch 18 to be stabilized. The edge portion of the notch 18 contacts the step portion 34D formed between the intermediate width portion 34B and the wide portion 34C, thereby enabling the compression amount of the seal lip 50A to be made constant.

In addition, according to the present exemplary embodiment, the connector 30 includes a fastening portion 46, to which another component disposed inside the case main body 14 is fastened. As illustrated in Fig. 9, when another component, not illustrated in the drawings, is fastened to the fastening portion 46 of the connector 30 by the screw 48, a force F that attempts to displace the connector 30 toward the front side is exerted by the tightening torque T of the screw 48; however, since the configuration is such that the edge portion of the notch 18 contacts the above-mentioned step portion 34D, the connector 30 can be prevented from being offset toward the front side with respect to the notch 18.

The present invention has been described above with reference to an exemplary embodiment; however, the present invention can be practiced with various modifications within a range that does not depart from the gist thereof. It is, of course, the case that the scope of rights of the present invention is not limited to the foregoing exemplary embodiment.

## Claims

1. A sealing structure (10) of an electrical component case, the structure comprising:
an electrical component case (12) having a bottomed-box-shaped case main body (14) with an opening portion (16) and a cover (24) that occludes the opening portion (16), the electrical component case (12) housing an electrical component, the electrical component case (12) being formed with a notch (18, 20, 22) at a peripheral wall (14B) of the case main body (14);
an attachment component (30) fitted into the notch (18, 20, 22) from a side of the opening portion (16); and
a resilient seal member (50) interposed between an edge portion of the notch (18, 20, 22) and the attachment component (30).

2. The sealing structure (10) of an electrical component case of claim 1, wherein the resilient seal member (50) is configured by a thermoplastic elastomer.

3. The sealing structure (10) of an electrical component case of claim 1 or claim 2, wherein the notch (18, 20, 22) forms an inverted trapezoidal shape that narrows on progression toward a bottom wall-side (14A) of the case main body (14).

4. The sealing structure (10) of an electrical component case of claim 1 or claim 2, wherein the resilient seal member (50) has a seal lip (50A) that protrudes toward the edge portion-side of the notch (18, 20, 22).

5. The sealing structure (10) of an electrical component case of claim 4, wherein the seal lip (50A) forms a substantially triangular cross section, and an apex point (P) of the cross section is offset toward one side in a thickness direction of the peripheral wall (14B).

6. The sealing structure (10) of an electrical component case of claim 1 or claim 2, wherein a groove (34) is formed at the attachment component (30), the resilient seal member (50) being provided at an inward side of the groove (34) and the edge portion of the notch (18, 20, 22) being fitted with an outward side of the groove (34).

7. The sealing structure (10) of an electrical component case of claim 6, wherein the inward side of the groove (34) is formed narrower than the outward side of the groove (34).

8. The sealing structure (10) of an electrical component case of claim 1 or claim 2, wherein the attachment component (30) has a fastening portion (46) disposed inside the case main body (14), to which another component is fastened.
